# EUROPEAN PATENT SPECIFICATION

(11) **EP 1 482 372 B1**
(45) Date of publication and mention of the grant of the patent: **08.10.2014**
(21) Application number: 04253057.6
(22) Date of filing: 25.05.2004
(51) Int. Cl.: G03F 7/20

(54) **Lithographic apparatus and device manufacturing method**
Lithographischer Apparat und Verfahren zur Herstellung einer Vorrichtung
Appareil lithographique et méthode de fabrication d'un dispositif

(30) Priority: 30.05.2003 EP 03253420
(43) Date of publication of application: 01.12.2004
(73) Proprietor: ASML Netherlands B.V., 5504 DR Veldhoven (NL)
(72) Inventor: Streefkerk, Bob, 5038 PE Tilburg (NL); Dierichs, Marcle Mathijs T. M., 5914 WR Venlo (NL); Gehoel-Van Ansem, W. F. J., 5563 AN Westerhoven (NL)
(74) Representative: Corcoran, Gregory Martin Mason

(56) References cited:
- US-A- 4 480 910
- US-A- 5 888 703
- US-A1- 2002 163 629

## Description

The present invention relates to a lithographic projection apparatus comprising:
- a radiation system for supplying a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate; and
- a liquid supply system for filling the space between the final element of said projection system and said substrate with a liquid.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096. In the case of a programmable mirror array, the said support structure may be embodied as a frame or table, for example, which may be fixed or movable as required.
- A programmable LCD array. An example of such a construction is given in United States Patent US 5,229,872. As above, the support structure in this case may be embodied as a frame or table, for example, which may be fixed or movable as required.
For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g.* comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus --commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791.

In order to reduce the size of features that can be imaged on a substrate, it has previously been proposed that the substrate be immersed in a liquid having a relatively high refractive index, e.g. water. The immersion liquid typically fills the space between the final element of the projection lens and the substrate, such that the exposure radiation in this region will have a shorter wavelength. (The effect of the liquid may also be regarded as increasing the effective NA of the system).

However, submersing the substrate or substrate and substrate table in a bath of liquid (see for example US 4,509,852) means that there is a large body of liquid that must be accelerated during a scanning exposure. This requires additional or more powerful motors and turbulence in the liquid may lead to undesirable and unpredictable effects.

One of the solutions proposed is for a liquid supply system to provide liquid in a localized area between the final element of the projection system and the substrate (the substrate generally has a larger surface area than the final element of the projection system). One way which has been proposed to arrange for this is disclosed in WO 99/49504.

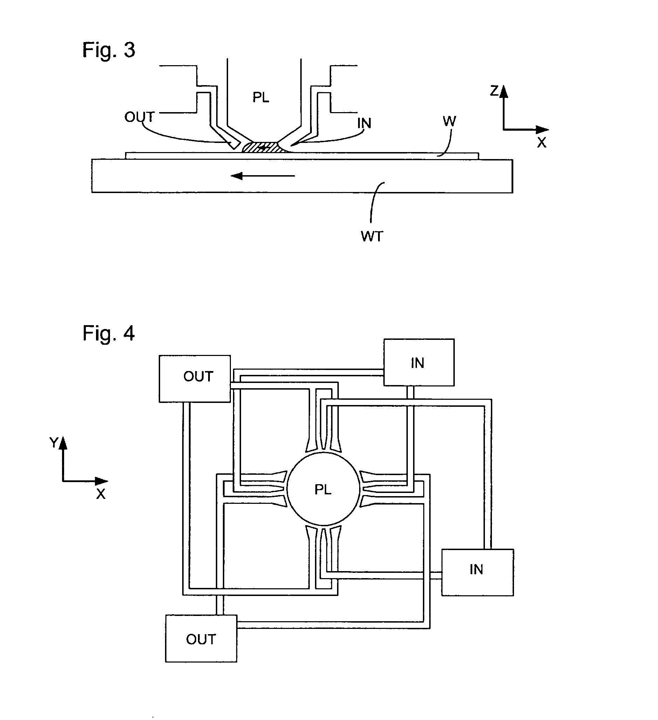

As illustrated in Figures 3 and 4, liquid is supplied by at least one outlet OUT onto the substrate, preferably along the direction of movement of the final element relative to the substrate, and is removed by at least one inlet IN after having passed under the projection system. That is, as the substrate is scanned beneath the element in a -X direction, liquid is supplied at the +X side of the element and taken up at the -X side. Figure 3 shows the arrangement schematically in which liquid is supplied via outlet OUT and is taken up on the other side of the element by inlet IN which is connected to a low pressure source. In the illustration of Figure 3 liquid is supplied along the direction of movement of the final element relative to the substrate, though this does not need to be the case. Various orientations and numbers of in-and out-lets positioned around the final element are possible, one example is illustrated in Figure 4 in which four sets of an inlet with an outlet on either side are provided in a regular pattern around the final element.

Another solution which has been proposed is to provide the liquid supply system with a seal member which extends along at least a part of a boundary of the space between the final element of the projection system and the substrate table. The seal member is substantially stationary relative to the projection system in the XY plane and a seal is formed between the seal member and the surface of the substrate. Preferably the seal is a contactless seal such as a gas seal.

In all of these systems, however, the immersion of the substrate during exposure leads to dissolution of the chemically amplified photo-resist which is typically used at the surface of the substrate. This causes degradation in the upper layer of the photo-resist. Furthermore, the uneven nature of the photo-resist after degradation can bring about the occurrence of T-topping during development. The developer is able to dissolve the underneath areas of the photo-resist that have not been degraded during immersion, but the degraded areas at the surface cannot be developed uniformly. This leads to the formation of an undesirable mushroom shape in the developed area.

US4,480, 910 discusses a pattern forming apparatus for projecting a pattern created on a reticle through a liquid layer on to a photoresist layer on a substrate. US2002/0163629 relates to a perfluoropolyether (PFPE) index matching medium which may be used as an immersion fluid in an immersion lithographic system. US 5,888,703 relates to an anti-reflective layer comprising a resin binder component. The anti-reflective layer is said to provide excellent anti-reflective properties in a predetermined UV wavelength region when used in photolithography.

It is an object of the present invention to provide a lithographic projection apparatus in which exposure takes place whilst a part of the substrate surface is immersed, but which reduces or avoids degradation of the photo-resist present on that part of the substrate surface.

This and other objects are achieved according to the invention in a lithographic apparatus as specified in the opening paragraph, wherein said liquid supply system comprises a liquid source containing said liquid, characterized in that the liquid is an aqueous solution having a pH of 6.5 or less.

The acidic nature of the immersion liquid significantly reduces the degradation effects which are a problem with prior art immersion lithography systems. This is because the photo-acids that are produced as a result of exposure, are significantly less soluble in acidic aqueous solutions than they are in water or other neutral species. The immersion liquids of the present invention therefore decrease dissolution of the surface layers of the photo-resist. T-topping is also reduced.

A preferred immersion liquid comprises topcoat, for example anti-reflective topcoat. Anti-reflective topcoat is acidic and therefore its addition to the immersion liquid will generate the desired low pH. The use of topcoat also has the advantage that when the substrate is withdrawn from a position where a part of the substrate surface is immersed in the immersion liquid, a thin film of topcoat remains on its surface. The presence of the topcoat protects the substrate surface from further degradation by chemicals in the environment.

In particular, reaction with amines is substantially prevented, thereby further reducing T-topping. Thus, the use of an anti-reflective topcoat solution in the immersion liquid obviates the requirement to remove amines from the atmosphere in which the exposed substrate is placed. Charcoal filters, for example, are no longer necessary.

In a preferred feature of the invention, the liquid supply system comprises liquid removal means to remove the liquid from the surface of the substrate, wherein said liquid removal means is adapted to leave on the surface of said substrate a film of said liquid. The film typically has a thickness in the order of 1 µm or less. This aspect of the invention further assists in preventing contamination of the exposed substrate by providing a barrier, in the form of a film of immersion liquid, between the sensitive substrate surface and the atmosphere. Particular advantages are obtained when the immersion liquid contains topcoat as mentioned above. Futher preferred featuresare specified in the dependent claims.

According to a further aspect of the invention there is provided a device manufacturing method comprising the steps of:- providing a substrate that is at least partially covered by a layer of radiation-sensitive material; - providing a projection beam of radiation using a radiation system; - using patterning means to endow the projection beam with a pattern in its cross- section;
- projecting the patterned beam of radiation onto a target portion of the layer of radiation-sensitive material; and
- providing liquid to fill the space between the substrate and a final element of a projection system used in said step of projecting;
characterized in that said liquid is an aqueous solution having a pH of 6.5 or less.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e.g.* with a wavelength of 365, 248, 193, 157 or 126 nm) and EUV (extreme ultra-violet radiation, *e.g.* having a wavelength in the range 5-20 nm).

Embodiments of the invention will now be described, by way of example only, with reference to the accompanying schematic drawings in which:
Figure 1 depicts a lithographic projection apparatus according to an embodiment of the invention;
Figure 2 depicts a liquid supply system according to an embodiment of the invention;
Figure 3 depicts an alternative liquid supply system; and
Figure 4 depicts an example of the orientations of inlets and outlets of the liquid supply system of Figure 3.

In the Figures, corresponding reference symbols indicate corresponding parts.

### Embodiment 1

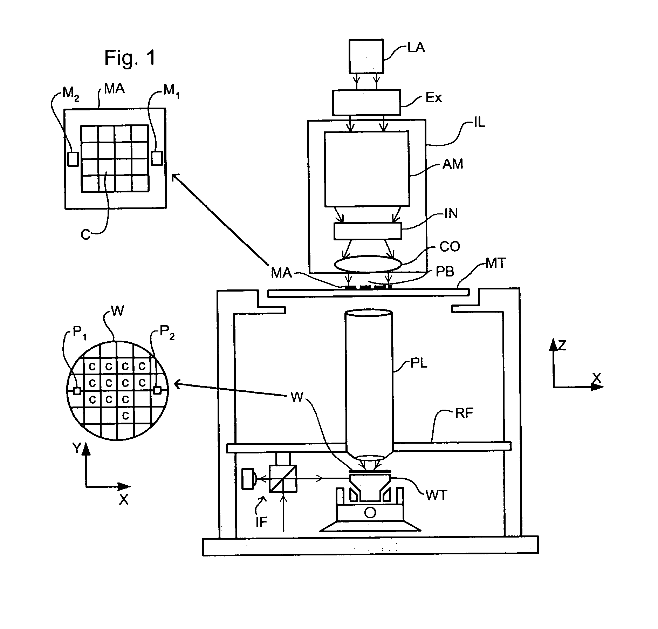

Figure 1 schematically depicts a lithographic projection apparatus according to a particular embodiment of the invention. The apparatus comprises:
· a radiation system Ex, IL, for supplying a projection beam PB of radiation (*e.g.* DUV radiation), which in this particular case also comprises a radiation source LA;
· a first object table (mask table) MT provided with a mask holder for holding a mask MA (*e.g.* a reticle), and connected to first positioning means for accurately positioning the mask with respect to item PL;
· a second object table (substrate table) WT provided with a substrate holder for holding a substrate W (*e.g.* a resist-coated silicon wafer), and connected to second positioning means for accurately positioning the substrate with respect to item PL;
· a projection system ("lens") PL (*e.g.* a refractive lens system) for imaging an irradiated portion of the mask MA onto a target portion C (*e.g.* comprising one or more dies) of the substrate W.
As here depicted, the apparatus is of a transmissive type (*e.g.* has a transmissive mask). However, in general, it may also be of a reflective type, for example (*e.g.* with a reflective mask). Alternatively, the apparatus may employ another kind of patterning means, such as a programmable mirror array of a type as referred to above.

The source LA (*e.g.* an excimer laser) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (*e.g.* with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having traversed by the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:
1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", *e.g.* the y direction) with a speed *v*, so that the projection beam PB is caused to scan over a mask image; concurrently, the substrate table WT is simultaneously moved in the same or opposite direction at a speed *V* = *Mv*, in which *M* is the magnification of the lens PL (typically, *M* = 1/4 or 1/5). In this manner, a relatively large target portion C can be exposed, without having to compromise on resolution.

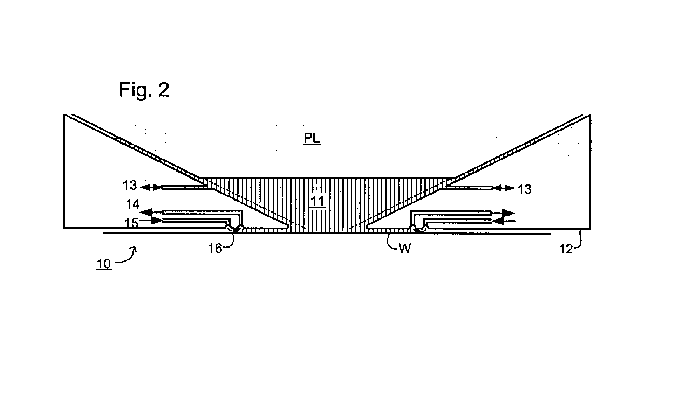

Figure 2 shows the liquid reservoir 10 between the projection system and the substrate stage in an embodiment of the invention. The liquid reservoir 10 is filled with a liquid 11 having a relatively high refractive index, provided via inlet/outlet ducts 13. A liquid source containing the liquid is provided which is used to fill the reservoir via inlet ducts 13. The liquid has the effect that the radiation of the projection beam has a shorter wavelength in the liquid than in air or a vacuum, allowing smaller features to be resolved. It is well known that the resolution limit of a projection system is determined, *inter alia,* by the wavelength of the projection beam and the numerical aperture of the system. The presence of the liquid may also be regarded as increasing the effective numerical aperture. Furthermore, at fixed numerical aperture, the liquid is effective to increase the depth of field.

Figures 3 and 4 depict the liquid supply system of an alternative embodiment of the invention. The details of this system have been discussed further above.

The liquid used in the present invention is an aqueous solution having a pH of 6.5 or less, for example 6 or less, 5 or less or even 4 or less, i.e. the liquid is acidic.

Homogeneous liquids are preferred, to ensure that the acidity is present throughout the liquid and therefore that the entire applicable surface of the substrate is in contact with acidic solution. The liquid should also be stable when irradiated at the wavelength used for the projection beam. Typically, the liquid should be stable when irradiated at one or more commonly used wavelengths, for example 193nm and 248nm.

The addition of a solute can affect the transmissivity and refractive index of water. The concentration of the solute should therefore be kept to a suitable level, to ensure that transmissivity at the wavelength used for the projection beam is maximized and so that a minimum effect is seen on the refractive index. Preferably, the liquid has a high transmissivity at one or more commonly used wavelengths, for example 193nm and 248nm. Further, the concentration of solute is preferably such that the refractive index of the water is not altered substantially. The solute concentration may vary depending on the solute used. However, examples of suitable solutions have a water content of at least 90wt%, for example at least 95wt% or at least 99wt%.

In a preferred embodiment of the invention the liquid is an aqueous topcoat solution, for example an anti-reflective topcoat solution. Anti-reflective topcoats are well known in the art and are available commercially. Examples include the anti-reflective topcoat solutions AZ AQUATAR and JSR NFC540 which can be obtained from Clariant (Japan) K.K. and JSR respectively. These topcoat solutions typically comprise greater than 90wt% water. However, in order to improve transmissivity, the solutions are typically further diluted. For example, the solution AZ AQUATAR-6 is preferably diluted in a ratio of about 1:10 (topcoat solution:water).

An example of an active ingredient of an anti-reflective topcoat solution is a fluoroalkylsulfonic acid. Suitable liquids for use as the immersion liquid of the present invention thereof include aqueous solutions containing one or more fluoroalkylsulfonic acids optionally together with one or more fluoroalkylsulfonic acid salts.

The acidic nature of anti-reflective topcoats provides the liquid with the desired acidity and thus reduces degradation of the photo-resist. An anti-reflective topcoat solution, or a fluoroalkylsulfonic acid is therefore useful as an acidity regulator in a liquid for use in the method of the present invention.

A liquid supply system for use in the present invention is that depicted in Figure 2. The reservoir 10 forms a contactless seal to the substrate around the image field of the projection system so that liquid is confined to fill a space between the substrate surface and the final element of the projection system. The reservoir is formed by a seal member 12 positioned below and surrounding the final element of the projection system PL. Liquid is brought into the space below the projection system and within the seal member 12. The seal member 12 extends a little above the final element of the projection system and the liquid level rises above the final element so that a buffer of liquid is provided. The seal member 12 has an inner periphery that at the upper end closely conforms to the step of the projection system or the final element thereof and may, e.g., be round. At the bottom, the inner periphery closely conforms to the shape of the image field, e.g., rectangular though this need not be the case.

The liquid is confined in the reservoir by a gas seal 16 between the bottom of the seal member 12 and the surface of the substrate W. The gas seal is formed by gas, e.g. air or synthetic air but preferably N₂ or another inert gas, provided under pressure via inlet 15 to the gap between seal member 12 and substrate and extracted via outlet 14. The overpressure on the gas inlet 15, vacuum level on the outlet 14 and geometry of the gap are arranged so that there is a high-velocity air flow inwards that confines the liquid.

The gas outlet system can also be used to remove the liquid from the system, thus acting as a liquid removal means. This is achieved by reducing the gas inlet pressure and allowing the liquid to be sucked out by the vacuum system, which can easily be arranged to handle the liquid, as well as the gas used to form the seal. In this way, the gas outlet system can be used to remove excess water from the substrate surface after exposure. The substrate W is taken out of the system and, as the substrate passes gas outlet 14, liquid is removed by the vacuum system. Advantageously, the gas outlet system is adapted to leave on the surface of the substrate a film of liquid. This film should be thin, for example in the order of 1µm or less, or 60nm or less. Control means are preferably provided to control the thickness of the film left on the substrate surface, for example by controlling the vacuum applied at gas outlet 14.

An alternative embodiment of the invention employs the liquid supply system depicted in Figures 3 and 4. In this embodiment, at least one inlet IN typically acts as the liquid removal means. Thus, as the substrate is extracted from the system, at least one inlet IN takes up any excess liquid remaining on the substrate surface. If desired, the inlet(s) may be adapted to leave a film of liquid on the surface of the substrate. This film should be thin, for example in the order of 1µm or less, or 60nm or less. Control means may be provided to control the thickness of the film left on the substrate surface, for example by controlling a vacuum or low pressure source connected to the inlet(s) IN.

Whilst a film of liquid is desirably left on the surface of the substrate, it is not necessary to leave liquid on the surface of an alignment mask or system when exposure is, or has been, carried out. Thus, control means provided to control the thickness of the film can be adapted as necessary (for example by increasing the vacuum) to remove all liquid from the surface of the alignment mask or system after exposure.

Whilst specific embodiments of the invention have been described above, it will be appreciated that the invention may be practiced otherwise than as described. The description is not intended to limit the invention.

## Claims

1. A lithographic projection apparatus comprising:
- a radiation system (Ex, IL) for providing a projection beam (PB) of radiation;
- a support structure (MT) for supporting patterning means (MA), the patterning means serving to pattern the projection beam according to a desired pattern;
- a substrate table (WT) for holding a substrate (W);
- a projection system (PL) for projecting the patterned beam onto a target portion of the substrate (W); and
- a liquid supply system for filling the space between the final element of said projection system and said substrate with a liquid, wherein said liquid supply system comprises a liquid source containing said liquid,**characterized in that** the liquid is an aqueous solution having a pH of 6.5 or less.

2. An apparatus according claim 1, wherein said liquid contains one or more fluoroalkylsulfonic acids.

3. An apparatus according to claim 1 or claim 2, wherein said liquid supply system comprises liquid removal means (14) to remove the liquid from the surface of the substrate, wherein said liquid removal means is adapted to leave on the surface of said substrate a film of said liquid.

4. An apparatus according to any of claims 1 or 2, wherein the liquid supply system comprises a seal member (12) extending along at least a part of the boundary of said space between the final element of said projection system (PL) and said substrate table (WT) and which is stationary relative to said projection system; and a gas seal means for forming a gas seal (16) between said seal member (12) and the surface of said substrate (W).

5. An apparatus according to claim 4, wherein said gas seal means comprises a gas inlet (15) and a gas outlet (14) formed in the face of a part that opposes said substrate (W), means for supplying gas under pressure to said gas inlet and vacuum means for extracting gas from said outlet.

6. An apparatus according to any one of claims 1 to 3, wherein the liquid supply system comprises:
- at least one outlet OUT for supplying liquid to the space between the final element of the projection system and the substrate; and
- at least one inlet IN for removing liquid from the space between the final element of the projection system and the substrate.

7. An apparatus according to any of claims 5 or 6, wherein said vacuum means or said at least one inlet IN is a liquid removal means for removing the liquid from the surface of the substrate, said vacuum means or said at least one inlet IN being adapted to leave on the surface of said substrate a film of said liquid.

8. A device manufacturing method comprising the steps of:
- providing a substrate (W) that is at least partially covered by a layer of radiation-sensitive material;
- providing a projection beam of radiation (PB) using a radiation system (Ex, IL);
- using patterning means (MA) to endow the projection beam (PB) with a pattern in its cross-section;
- projecting the patterned beam of radiation onto a target portion of the layer of radiation-sensitive material; and
- providing liquid to fill the space between the substrate (W) and a final element of a projection system (PL) used in said step of projecting;
**characterized in that** said liquid is an aqueous solution having a pH of 6.5 or less.

## Patentansprüche

1. Ein lithographisches Projektionsgerät, das Folgendes beinhaltet:
- ein Strahlungssystem (Ex, IL) zum Bereitstellen eines Projektionsstrahls (PB) aus Strahlung;
- eine Stützstruktur (MT) zum Stützen eines Musteraufbringungsmittels (MA), wobei das Musteraufbringungsmittel dazu dient, den Projektionsstrahl gemäß einem gewünschten Muster zu mustern;
- einen Substrattisch (WT) zum Halten eines Substrats (W);
- ein Projektionssystem (PL) zum Projizieren des gemusterten Strahls auf einen Zielabschnitt des Substrats (W); und
- ein Flüssigkeitszufuhrsystem, um den Raum zwischen der Endkomponente des Projektionssystems und dem Substrat mit einer Flüssigkeit zu füllen, wobei das Flüssigkeitszufuhrsystem eine Flüssigkeitsquelle beinhaltet, die die Flüssigkeit enthält, **dadurch gekennzeichnet, dass** die Flüssigkeit eine wässrige Lösung mit einem pH von 6,5 oder weniger ist.

2. Gerät gemäß Anspruch 1, wobei die Flüssigkeit eine oder mehrere Fluoralkylsulfonsäuren enthält.

3. Gerät gemäß Anspruch 1 oder Anspruch 2, wobei das Flüssigkeitszufuhrsystem ein Flüssigkeitsentfernungsmittel (14) zum Entfernen der Flüssigkeit von der Oberfläche des Substrats beinhaltet, wobei das Flüssigkeitsentfernungsmittel angepasst ist, um auf der Oberfläche des Substrats einen Film der Flüssigkeit zurückzulassen.

4. Gerät gemäß einem der Ansprüche 1 oder 2, wobei das Flüssigkeitszufuhrsystem Folgendes beinhaltet: ein Dichtungselement (12), das sich entlang mindestens einem Teil der Grenze des Raums zwischen der Endkomponente des Projektionssystems (PL) und dem Substrattisch (WT) erstreckt und das relativ zu dem Projektionssystem stationär ist; und ein Gasdichtungsmittel zum Bilden einer Gasdichtung (16) zwischen dem Dichtungselement (12) und der Oberfläche des Substrats (W).

5. Gerät gemäß Anspruch 4, wobei das Gasdichtungsmittel Folgendes beinhaltet: einen Gaseinlass (15) und einen Gasauslass (14), die in der Fläche eines Teils, welches dem Substrat (W) gegenüberliegt, gebildet sind, ein Mittel zum Zuführen von Gas unter Druck zu dem Gaseinlass und ein Vakuummittel zum Extrahieren von Gas aus dem Auslass.

6. Gerät gemäß einem der Ansprüche 1 bis 3, wobei das Flüssigkeitszufuhrsystem Folgendes beinhaltet:
- mindestens einen Auslass OUT zum Zuführen von Flüssigkeit zu dem Raum zwischen der Endkomponente des Projektionssystems und dem Substrat; und
- mindestens einen Einlass IN zum Entfernen von Flüssigkeit aus dem Raum zwischen der Endkomponente des Projektionssystems und dem Substrat.

7. Gerät gemäß einem der Ansprüche 5 oder 6, wobei das Vakuummittel oder der mindestens eine Einlass IN ein Flüssigkeitsentfernungsmittel zum Entfernen der Flüssigkeit von der Oberfläche des Substrats ist, wobei das Vakuummittel oder der mindestens eine Einlass IN angepasst ist, um auf der Oberfläche des Substrats einen Film der Flüssigkeit zurückzulassen.

8. Ein Verfahren zum Herstellen einer Vorrichtung, das die folgenden Schritte beinhaltet:
- Bereitstellen eines Substrats (W), das mindestens teilweise mit einer Schicht aus strahlungsempfindlichem Material überzogen ist;
- Bereitstellen eines Projektionsstrahls aus Strahlung (PB) unter Verwendung eines Strahlungssystems (Ex, IL);
- Verwenden eines Musteraufbringungsmittels (MA), um den Projektionsstrahl (PB) in seinem Querschnitt mit einem Muster zu versehen;
- Projizieren des gemusterten Strahls aus Strahlung auf einen Zielabschnitt der Schicht aus strahlungsempfindlichem Material; und
- Bereitstellen einer Flüssigkeit, um den Raum zwischen dem Substrat (W) und einer in dem Schritt des Projizierens verwendeten Endkomponente eines Projektionssystems (PL) zu füllen;
**dadurch gekennzeichnet, dass** die Flüssigkeit eine wässrige Lösung mit einem pH von 6,5 oder weniger ist.

## Revendications

1. Un appareil de projection lithographique comprenant :
- un système de rayonnement (Ex, IL) destiné à fournir un faisceau de projection (PB) de rayonnement ;
- une structure formant support (MT) destinée à supporter un moyen pour conformer selon un motif (MA), le moyen pour conformer selon un motif servant à conformer le faisceau de projection selon un motif souhaité ;
- une table porte-substrat (WT) destinée à porter un substrat (W) ;
- un système de projection (PL) destiné à projeter le faisceau à motif sur une portion cible du substrat (W) ; et
- un système d'amenée de liquide destiné à remplir l'espace entre l'organe final dudit système de projection et ledit substrat avec un liquide, ledit système d'amenée de liquide comprenant une source de liquide contenant ledit liquide, **caractérisé en ce que** le liquide est une solution aqueuse ayant un pH de 6,5 ou moins.

2. Un appareil selon la revendication 1, dans lequel ledit liquide contient un ou plusieurs acides fluoroalkylsulfoniques.

3. Un appareil selon la revendication 1 ou la revendication 2, dans lequel ledit système d'amenée de liquide comprend un moyen de retrait de liquide (14) afin de retirer le liquide de la surface du substrat, ledit moyen de retrait de liquide étant conçu pour laisser sur la surface dudit substrat un film dudit liquide.

4. Un appareil selon n'importe lesquelles des revendications 1 ou 2, dans lequel le système d'amenée de liquide comprend un élément d'étanchéité (12) s'étendant le long d'au moins une partie du pourtour dudit espace entre l'organe final dudit système de projection (PL) et ladite table porte-substrat (WT) et qui est stationnaire relativement audit système de projection ; et un moyen d'étanchéité à gaz destiné à former un joint de gaz (16) entre ledit élément d'étanchéité (12) et la surface dudit substrat (W).

5. Un appareil selon la revendication 4, dans lequel ledit moyen d'étanchéité à gaz comprend un orifice d'entrée de gaz (15) et un orifice de sortie de gaz (14) formés dans la face d'une partie qui est face audit substrat (W), un moyen pour amener du gaz sous pression audit orifice d'entrée de gaz et un moyen à vide pour extraire du gaz dudit orifice de sortie.

6. Un appareil selon l'une quelconque des revendications 1 à 3, dans lequel le système d'amenée de liquide comprend :
- au moins un orifice de sortie OUT destiné à amener du liquide dans l'espace entre l'organe final du système de projection et le substrat ; et
- au moins un orifice d'entrée IN destiné à retirer du liquide de l'espace entre l'organe final du système de projection et le substrat.

7. Un appareil selon n'importe lesquelles des revendications 5 ou 6, dans lequel ledit moyen à vide ou ledit au moins un orifice d'entrée IN est un moyen de retrait de liquide destiné à retirer le liquide de la surface du substrat, ledit moyen à vide ou ledit au moins un orifice d'entrée IN étant conçu pour laisser sur la surface dudit substrat un film dudit liquide.

8. Un procédé de fabrication de dispositif comprenant les étapes consistant :
- à fournir un substrat (W) qui est au moins en partie recouvert d'une couche de matériau sensible au rayonnement ;
- à fournir un faisceau de projection de rayonnement (PB) à l'aide d'un système de rayonnement (Ex, IL) ;
- à utiliser un moyen pour conformer selon un motif (MA) afin de doter le faisceau de projection (PB) d'un motif dans sa coupe transversale ;
- à projeter le faisceau de rayonnement à motif sur une portion cible de la couche de matériau sensible au rayonnement ; et
- à fournir un liquide afin de remplir l'espace entre le substrat (W) et un organe final d'un système de projection (PL) utilisé lors de ladite étape de projection ;
**caractérisé en ce que** ledit liquide est une solution aqueuse ayant un pH de 6,5 ou moins.
